# EUROPÄISCHE PATENTANMELDUNG

(11) **EP 1 582 606 A1**
(43) Veröffentlichungstag der Anmeldung: **05.10.2005**
(21) Anmeldenummer: 04007253.0
(22) Anmeldetag: 25.03.2004
(51) Int. Cl.: C23C 14/56

(54) **Vakuumbehandlungsanlage mit variabler Pumpanordnung**

(71) Anmelder: Applied Films GmbH & Co. KG, 63755 Alzenau (DE)
(72) Erfinder: Sauer, Andreas, 63762 Grossostheim (DE); Rödling, Gert, 63179 Obertshausen (DE)
(74) Vertreter: GROSSE BOCKHORNI SCHUMACHER

(57) **Zusammenfassung**

Vakuumbehandlungsanlage, insbesondere Beschichtungsanlage für die kontinuierliche Beschichtung durchlaufender, plattenartiger Substrate, vorzugsweise Glasbeschichtungsanlage mit mindestens einer, vorzugsweise mehreren hintereinander angeordneten Vakuumkammern (1) oder Kammerbereichen (2 bis 8, 17), die über mindestens eine, vorzugsweise mehrere Pumpeinrichtungen (21) abgepumpt werden, wobei mindestens eine Kammer oder ein Kammerbereich an der Kammeroberseite einen Deckel (20, 30) aufweist, an dem mindestens eine Pumpeinrichtung angeordnet ist und wobei der Deckel so ausgebildet ist, dass er einen Deckelraum (28) bildet und mit dem Deckelraum über die Kammer oder den Kammerbereichen übersteht.

## Beschreibung

Die vorliegende Erfindung betrifft eine Vakuumbehandlungsanlage nach dem Oberbegriff des Anspruchs 1 bzw. einen abnehmbaren Deckel hierfür.

Vakuumbehandlungsanlagen und insbesondere Beschichtungsanlagen für großformatige scheiben- oder plattenförmige Substrate, wie z. B. Architekturverglasungen, die in einer kontinuierlichen Weise die Beschichtungsanlagen durchlaufen, um beispielsweise mit Wärmeschutzschichten o. dgl. versehen zu werden, sind im Stand der Technik bekannt. Bei diesen Anlagen, bei denen eine Vielzahl von Kammern hintereinander angeordnet sind, um vielfältige Bearbeitungs- und Beschichtungsprozesse nacheinander ausführen zu können, müssen die Behandlungskammem für die verwendeten Beschichtungsverfahren auf sog. Vakuumbedingungen, also Atmosphären mit sehr niedrigen Drücken gebracht werden. Dazu werden üblicherweise zwei verschiedene Pumpenarten zur Erzielung der niedrigen Prozessdrücke eingesetzt und zwar einerseits Turbomolekularpumpen und andererseits Diffusionspumpen und hier insbesondere Öldiffusionspumpen. Diese Pumpen, die zusammen mit unterschiedlichen Vorpumpen eingesetzt werden, erzeugen die für die Beschichtungsprozesse erforderlichen Vakuum- bzw. Hochvakuumbedingungen und sind daher für Beschichtungsanlagen von entscheidender Bedeutung.

Nach dem Stand der Technik werden die Beschichtungsanlagen bzw. Vakuumanlagen jedoch bei der Konzeption auf eine Pumpenart ausgelegt, da die Anordnung und der Betrieb der Turbomolekularpumpen und Diffusionspumpen deutlich unterschiedlich ist. Während Turbomolekularpumpen in vielfältiger Weise an die Vakuumanlagen angeflanscht werden können, jedoch üblicherweise oberhalb der Vakuumanlage stehend angebaut werden, werden Diffusionspumpen und insbesondere Öldiffusionspumpen aufgrund ihrer Betriebsweise üblicherweise hängend bzw. in vertikaler Position direkt an die Prozesskammer angeflanscht. Aufgrund dieser festen Anordnung und der unterschiedlichen Art und Lage der Anordnung ist eine spätere Veränderung der Position der Diffusionspumpen oder sogar ein WechseI von einer Pumpenart auf eine andere Pumpenart nicht mehr möglich. Hierzu müssten die Kammern derartiger Vakuumanlagen mit Trennschleifern geöffnet bzw. die Diffusionspumpen abgebaut werden und durch Anschweißen anderer Anlagenteile ersetzt werden.

Es ist deshalb Aufgabe der vorliegenden Erfindung eine Vakuumanlage und insbesondere Beschichtungsanlage, vorzugsweise Glasbeschichtungsanlage zu schaffen, die bezüglich der verwendeten Vakuumpumpen und deren Positionierung variabel ist. Darüber hinaus soll eine derartige Anlage einfach aufgebaut und effektiv betreibbar sein.

Diese Aufgabe wird gelöst durch eine Vakuumbehandlungsanlage mit den Merkmalen des Anspruchs 1 bzw. mit einer Deckelanordnung für eine Prozesskammer einer Vakuumbehandlungsanlage mit den Merkmalen des Anspruchs 11. Vorteilhafte Ausgestaltungen sind Gegenstand der abhängigen Ansprüche.

Die Erfinder haben erkannt, dass eine variable Anordnung von Pumpeinrichtungen und insbesondere sogar ein Wechsel zwischen verschiedenen Vakuumpumparten in besonders einfacher Weise dann möglich sein sollte, wenn die für Turbomolekularpumpen bekannte Anordnungsweise an einem abnehmbaren Prozesskammerdeckel auch für Öldiffusionspumpanordnungen möglich ist. Erfindungsgemäß wird dies in einfacher Weise dadurch realisiert, dass ein Deckel einer Vakuumbehandlungskammer bzw. eines Kammerbereichs (Kompartment) so gestaltet wird, dass er einen Deckelraum einschließt (Kammerdeckel), über den ein Volumentransport von der Kammer über den Deckel ermöglicht wird. Dadurch wird erreicht, dass durch Bereitstellung eines ausreichend großen Saugleitwerts für den Deckel eine gleichmäßige Evakuierung über die Anlage durch Diffusionspumpen gewährleistet wird. Die Anschlusseinrichtungen für die Diffusions- und insbesondere Öldiffusionspumpen können an den Seiten oder der Unterseite des Deckels vorgesehen werden, wobei die Diffusionspumpen über entsprechende Adapter mit ausreichendem Saugleitwert angeschlossen werden können. Der Adapter kann somit eine gerade Verbindung zwischen Deckel und Pumpe herstellen oder über Eck führen. Vorzugsweise ist der Adapter mit einem sog. Baffle ausgestattet, welches durch gekühlte Prallbleche verhindert, dass Öl in den Deckelraum gelangt.

Vorteilhaft ist, dass der Kammerdeckel mit dem Deckelraum über die Kammer übersteht, um so Anordnungsmöglichkeiten für Pumpen, Zuleitungen u. dgl. nicht nur von der Oberseite oder von der Seite, sondern insbesondere auch von unten zu schaffen. Dies ermöglicht es in besonders einfacher Weise Öldiffusionspumpen direkt an dem Deckel oder über entsprechende Blend- oder Adapteranordnungen an diesem anzuordnen und die unter dem Deckel angeordnete Kammer bzw. das Kompartment über die Diffusionspumpe bzw. insbesondere Öldiffusionspumpe zu entlüften.

Hierbei hat es sich als vorteilhaft erwiesen, wenn der Deckel seitlich, also quer zur Substratförderrichtung über eine, vorzugsweise jedoch beide Seiten der Kammer übersteht, da hier dann die Möglichkeit gegeben ist, die Diffusionspumpen in einfacher Weise insbesondere auf beiden Seiten der Kammer anzuordnen, um so eine vorteilhafte Gasströmung im Deckel bzw. in der Kammer einzustellen. Vorzugsweise sind die Deckel mit entsprechenden Anschlusseinrichtungen für die Öldiffusionspumpen an der Unterseite der Deckel im überstehenden Bereich versehen, wobei diese Anschlusseinrichtungen vorzugsweise verschließbar ausgestaltet sind, um die Deckel auch dann einsetzen zu können, wenn keine Diffusionspumpen angeordnet sind.

Entsprechend können auch zusätzliche Anschlusseinrichtungen für weitere Pumpen insbesondere Turbomolekularpumpen an der Oberseite des Deckels vorgesehen werden, um den identischen Deckel sowohl einerseits für Turbomolekularpumpen als auch für Öldiffusionspumpen verwenden zu können. Es ist selbstverständlich, dass auch diese Anschlusseinrichtungen für die Turbomolekularpumpen an der Oberseite des Deckels vakuumdicht verschließbar ausgebildet sein sollten.

Da üblicherweise auch Prozesswerkzeuge über Öffnungen an der Oberseite der Prozesskammer eingeführt werden oder an entsprechenden Deckeln zum Verschließen dieser Öffnungen angeordnet sind, kann durch das zusätzliche oder alternative Vorsehen von Öldiffusionspumpen an gleichen oder vorzugsweise entsprechend anders gestalteten, erfindungsgemäßen Prozesskammerdeckeln eine besonders variable Nutzung der im Grundaufbau üblicherweise nahezu identischen Kompartments oder Kammern einer Vakuumbehandlungsanlage gewährleistet werden. Je nach Anwendungsfall bzw. Gestaltung der Vakuumbehandlungsanlage wird die Kammer oder das Kompartment mit einem entsprechenden Deckel verschlossen, z. B. mit einem flachen Deckel mit Turbomolekularpumpen, einem Deckel zusätzlich oder alternativ mit Prozesswerkzeugen oder Kammerdeckel zusätzlich oder alternativ mit Diffusionspumpen usw. Eine Umgestaltung oder Umrüstung ist dann in einfacher Weise dadurch möglich, dass die Deckel für die Kammern oder Kammerbereiche ausgetauscht werden. Soll beispielsweise eine Kammer statt mit Turbomolekularpumpen mit Öldiffusionspumpen abgepumpt werden, wird einfach der entsprechende Deckel für Turbomolekularpumpen durch einen für Diffusionspumpen ersetzt.

Eine besonders einfache Gestaltung des Deckels zur Bildung eines Gastransportraums bzw. Deckelraums ist durch eine quader- oder kastenförmige Gestaltung gewährleistet, wobei hier lediglich an der Unterseite des Deckels eine entsprechende Öffnung für die Verbindung zur Vakuumkammer bzw. den Kompartments der Vakuumkammer neben den vorher angesprochenen Anschlusseinrichtungen für die Pumpanordnungen vorgesehen sein muss.

Nach einer vorteilhaften Ausführungsform weist der Deckel mindestens ein Drosselventil auf, mittels dessen die Pumpleistung der angeschlossenen Pumpeinrichtung eingestellt und variiert werden kann. Vorzugsweise ist deshalb für jede Anschlusseinrichtung einer Pumpeinrichtung ein separates Drosselventil vorgesehen, welches beispielsweise gegenüberliegend der Anschlusseinrichtung vorgesehen sein kann.

Nach einer weiteren bevorzugten Ausführungsform weist das Drosselventil eine Verschlussklappe auf, die beispielsweise durch einen Lineartrieb bezüglich der Öffnung der Anschlusseinrichtung also in Bezug zu der Pumpeinrichtung bewegbar ist und im Extremfall die Öffnung der Anschlusseinrichtung bzw. den Zugang zur Pumpeinrichtung verschließen kann.

Um mit den an dem Deckel angeschlossenen Pumpeinrichtungen unterschiedliche Kammerbereiche oder Kompartmentbereiche abpumpen zu können, kann es vorteilhaft sein, wenn der Deckel Trenn- oder Leitbleche aufweist. Diese ist beispielsweise dann vorteilhaft, wenn ein Kammerbereich (Kompartment) als Teil einer Gastrennstufe ausgebildet ist, bei dem über einen Teil des Kompartments die benachbarte Kammer bzw. der benachbarte Kammerbereich abgepumpt und der andere Teil der Kammer zum direkten Abpumpen verwendet wird. Entsprechend sind dann auch in dem Kompartment Trenn- oder Leitbleche korrespondierend zu den Trenn- oder Leitblechen des Deckels vorgesehen. Nach einer bevorzugten Ausführungsform kann ein Trenn- oder Leitblech vorzugsweise nahezu diagonal in dem Deckelraum vorgesehen werden, um über die beiden seitlich angeordneten Pumpeinrichtungen zwei unterschiedliche Bereiche abzupumpen.

Weitere Vorteile, Kennzeichen und Merkmale der vorliegenden Erfindung werden bei der nachfolgenden detaillierten Beschreibung von bevorzugten Ausführungsbeispielen anhand der beigefügten Zeichnungen deutlich. Die Zeichnungen zeigen dabei in rein schematischer Weise in
- Fig. 1: eine Seitenansicht mit teilweisem Querschnitt entlang der Substratförderrichtung einer Glasbeschichtungsanlage;
- Fig. 2: eine Querschnittsansicht durch die Glasbeschichtungsanlage der Fig. 1 quer zur Transportrichtung;
- Fig. 3: eine Seitenansicht mit teilweisem Querschnitt entlang der Substratfördereinrichtung einer weiteren Ausführungsform einer Glasbeschichtungsanlage bzw. eines Kammerbereichs, bei der zur Veranschaulichung bestimmte Komponenten weggelassen wurden;
- Fig. 4: eine Ansicht gemäß der Fig. 3 mit teilweiser Darstellung der in Fig. 3 nicht gezeigten Komponenten;
- Fig. 5: eine Draufsicht auf einen Deckel mit schematischer Darstellung der Anschlüsse für die Diffusionspumpen und in
- Fig. 6: eine Draufsicht auf einen Deckel einer Glasbeschichtungsanlage mit Trennblech und schematischer Darstellung der Anschlüsse für die Diffusionspumpen.

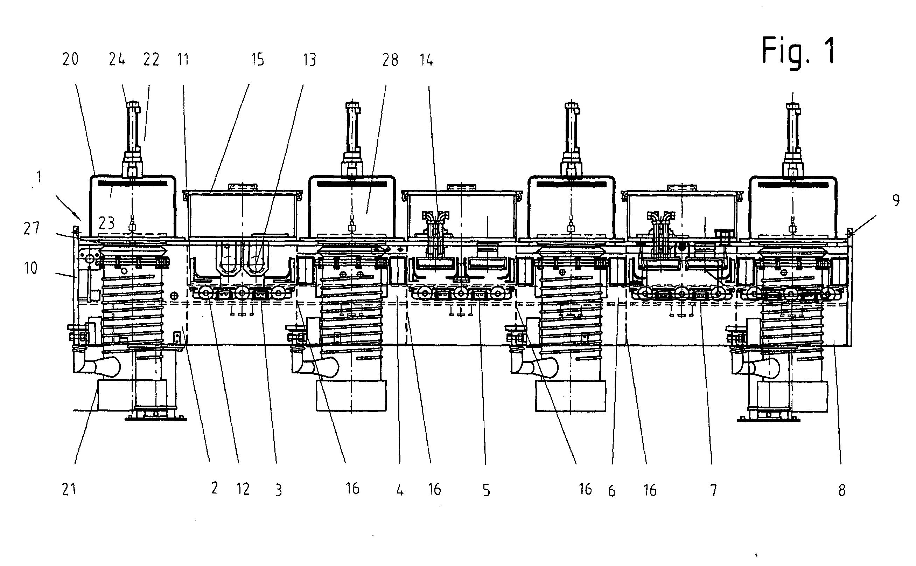

Fig. 1 zeigt in einer Seitenansicht mit teilweisem Querschnitt die Kammer 1 einer kontinuierlich arbeitenden Glasbeschichtungsanlage, die insgesamt sieben im Grundaufbau im wesentlichen gleiche Kompartments 2 bis 8 umfasst. Die im Grundaufbau nahezu identischen und daher universell verwendbaren Kompartments sind für unterschiedlichste Arbeitsschritte im Beschichtungsprozess mit unterschiedlichen Prozesswerkzeugen 13 und 14 ausgestattet (Kompartments 3, 5 und 7) oder dienen als Pumpkompartments (Kompartments 2, 4, 6 und 8), um die für den Beschichtungsprozess erforderlichen Vakuumbedingungen in der Kammer 1 bzw. den Kompartments 2 bis 8 zu erzeugen, wobei die Pumpkompartments (2, 4, 6, 8) die benachbarten Prozesskompartments mit abpumpen.

Für eine komplette Glasbeschichtungsanlage können mehrere derartige Kammern hintereinander angeordnet werden, wobei diese Kammern über die Kammerwände 9 und 10, die als Kammerflansche ausgeführt sind, vakuumdicht verbunden werden.

Die einzelnen Kompartments 2 bis 8 sind durch Trennwände 16 voneinander abgetrennt, um einen Atmosphärenaustausch zwischen den einzelnen Kompartments zu vermeiden. Dies ist insbesondere bei unterschiedlichen aufeinanderfolgenden Beschichtungsschritten unerlässlich.

Die zu beschichtenden Substrate werden über eine als Rollenförderer 12 ausgebildete Transporteinrichtung horizontal liegend durch die Kammer 1 bzw. die Kompartments 2 bis 8 hindurch befördert, wobei in den Trennwänden 16 jeweils Schlitzschleusen (nicht gezeigt) vorgesehen sind, so dass ein kontinuierliches Durchlaufen der Substrate durch die Kammer 1 bzw. die Kompartments 2 bis 8 gewährleistet ist. Die Substrattransportebene 11 ist in Fig. 1 mit einer Punkt-Strich-Linie dargestellt.

Die Kompartments weisen an der Oberseite jeweils eine Öffnung auf, über die beispielsweise Prozesswerkzeuge eingebracht werden können.

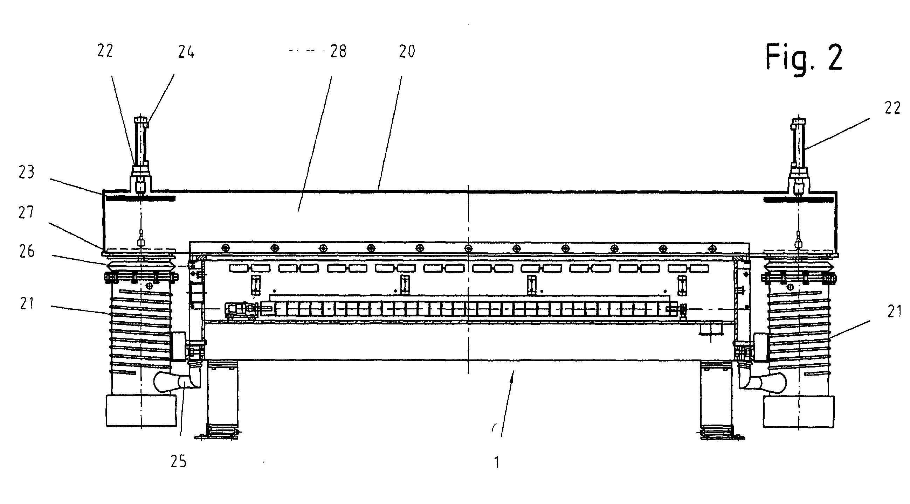

An den Pumpkompartments 2, 4, 6 und 8 ist an der Kammeroberseite jeweils ein abnehmbarer Deckel 20 und an den Prozesskompartments 3, 5 und 7 jeweils ein abnehmbarer Deckel 15 vorgesehen, die eine entsprechende Öffnung des Kompartments bzw. der Kammer 1 vakuumdicht abschließen. Der Deckel 15 umfasst teilweise Prozesswerkzeuge 14. Wie sich insbesondere aus Fig. 2 in der Schnittansicht quer zur Transportrichtung der Substrate ergibt, ist der Deckel 20 in seiner Dimension quer zur Substratförderichtung größer ausgebildet als die Kammer 1, so dass der Deckel 20 an beiden Seiten übersteht.

In den überstehenden Bereichen ist an der Unterseite des Deckels 20 jeweils eine Öldiffusionspumpe 21 über einen Adapter 26, ein sog. Baffle an einer im Deckel vorgesehenen Anschlusseinrichtung 27 angeordnet. Die Anschlusseinrichtung 27 umfasst eine Durchtrittsöffnung, mit der eine Verbindung zwischen der Öldiffusionspumpe 21 und dem von dem Deckel 20 umschlossenen Deckeraum 28 gebildet wird, sowie nicht näher dargestellte Mittel zum vakuumdichten Anschließen der Diffusionspumpe 21 bzw. eines zwischen der Anschlusseinrichtung 27 und der Diffusionspume 21 vorgesehenen Adapters 26. Der Adapter bzw. das Baffle 26 weist ein Prallblech aus mehreren, wassergekühlten Lamellen auf, die sich so überlappen, dass eine gerade Verbindung durch die Lamellen verhindert wird (optisch undurchsichtig), gleichzeitig einem Gasstrom jedoch ein geringer Widerstand entgegen gesetzt wird, so dass Öldampf von der Öldiffusionspumpe am Eintritt in den Deckel oder die Kammer gehindert wird, aber ein Absaugen möglich ist.

Der durch den quader- bzw. kastenförmigen Aufbau des Deckels 20 gebildete Deckelraum 28 gewährleistet eine funktionswirksame Verbindung zwischen der Öldiffusionspumpe 21 und den entsprechenden Kompartments 2, 4, 6 und 8 der Kammer 1 zum Abpumpen der Kompartments.

Um die Saugleistung variieren zu können, sind gegenüberliegend den Anschlusseinrichtungen 27 an der Oberseite des Deckels 20 Ventileinrichtungen 22 vorgesehen, mit denen die Saugleistung gedrosselt werden kann. Hierzu weisen die Drosselventile 22 einen Ventilteller 23 auf, der im Extremfall die Öffnung der Anschlusseinrichtung 27 verschließen kann, wie die Strichlinie die Darstellung in den Fig. 1 und 2 zeigt. Somit kann das Drosselventil 22 auch als Verschluss für die Anschlusseinrichtung 27 dienen.

Der Ventilteller 23 ist über einen Linearantrieb 24 translatorisch in vertikaler Richtung bewegbar, so dass er von der Öffnung der Anschlusseinrichtung 27 abgehoben und auf diese abgesenkt werden kann. Dadurch kann die Saugleistung der Öldiffusionspumpe 21 entsprechend eingestellt werden.

Die Anschlüsse der Öldiffusionspumpe 21, beispielsweise der Anschluss 25 an die Vorpumpe, sowie die Anschlüsse für die Kühlleitungen, die elektrische Versorgung usw. können in günstiger Weise seitlich entlang der Vakuumkammer 1 geführt werden, und zwar in dem vom Deckel 20 überdeckten seitlichen Raum neben der Vakuumkammer 1. Insofern bietet die erfindungsgemäße Gestaltung auch die Möglichkeit die Anlagenperipherie raumsparend und geschützt anzuordnen.

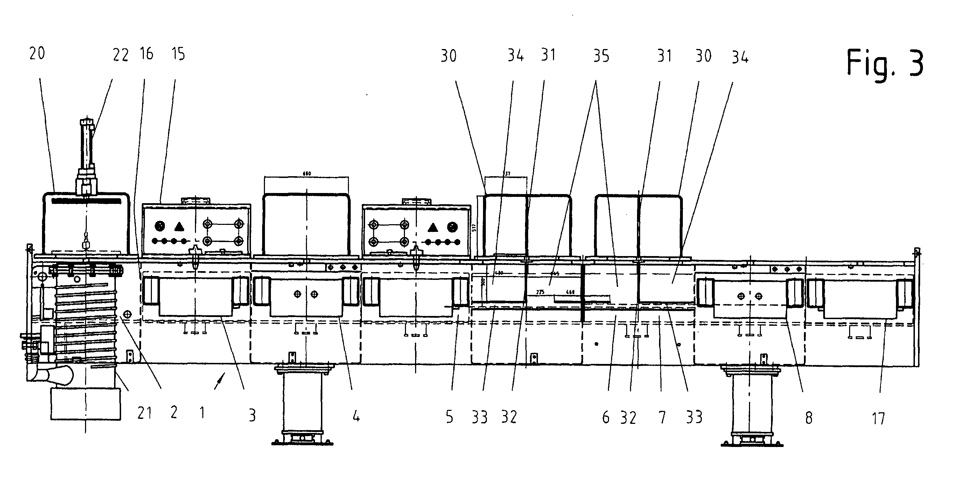

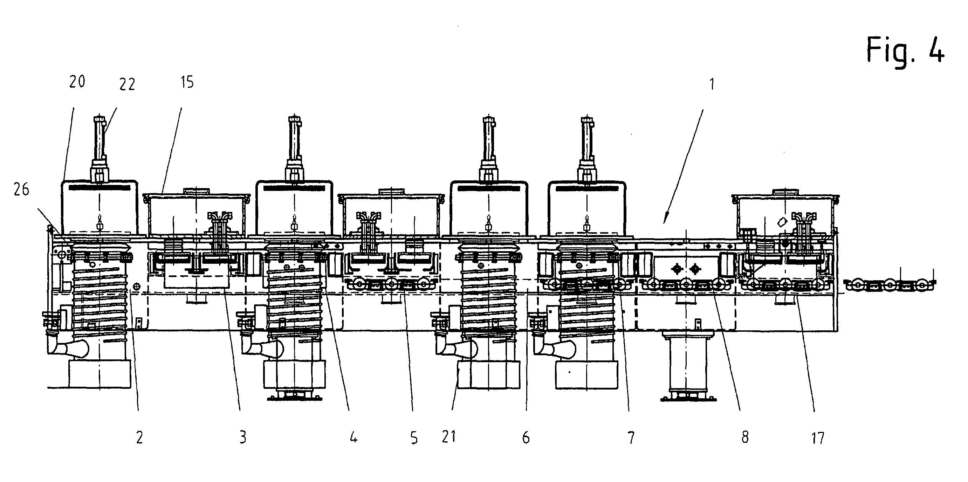

Die Fig. 3 und 4 zeigen in einer Seitenansicht mit teilweisen Querschnitten unterschiedliche Komponenten einer weiteren Ausführungsform einer Beschichtungskammer 1 mit mehreren Kompartments 2 bis 8 und 17 einer Glasbeschichtungsanlage. Diese Kammer stimmt in vielen Gestaltungsmerkmalen mit der Ausführungsform der Fig. 1 und 2 überein oder ist sehr ähnlich ausgebildet, so dass für identische oder weitgehend ähnliche Komponenten dieselben Bezugszeichen verwendet werden und im übrigen im wesentlichen auf die unterschiedlichen Gestaltungen eingegangen wird.

Die Kammer 1 der Fig. 3 und 4 unterscheidet sich zunächst von der Ausführungsform gemäß der Fig. 1 und 2 dadurch, dass ein Kompartment zusätzlich vorgesehen ist und zwar das Kompartment 17. Darüber hinaus besteht der wesentliche Unterschied darin, dass die nebeneinander angeordneten Kompartments 6 und 7 als Gastrennstufe ausgebildet sind, um für die benachbarten Beschichtungs- bzw. Bearbeitungsprozesse in den Kompartments 5 und 8 bzw. 17 eine besonders sichere und hochwertige Abrennung der Atmosphärenräume sicher zu stellen.

Die Gastrennstufe in den Kompartments 6 und 7 ist so aufgebaut, dass sowohl in den Deckeln 30 als auch in den Kompartments 6 und 7 jeweils eine Trennwand 31 bzw. 32 quer zur Substrattransportrichtung vorgesehen ist, um den Kompartmentraum bzw. den Deckelraum in zwei Teile zu trennen.

In den Kompartments 6 und 7 entsteht somit jeweils angrenzend zu den benachbarten Kompartments 5 bzw. 8 ein gegenüber dem übrigen Raum abgetrennter Kompartmentraum 34, der zusätzlich zur Transporteinrichtung über eine Schlitzschleuse 33 abgetrennt ist. Über diesen Kompartmentraum 34, der zu den benachbarten Kompartments offen ist, erfolgt das Abpumpen der benachbarten Kompartments 5 bzw. 8, während der übrige Kompartmentraum 35 jeweils angrenzend an das benachbarte Kompartment 6 bzw. 7 separat abgepumpt wird.

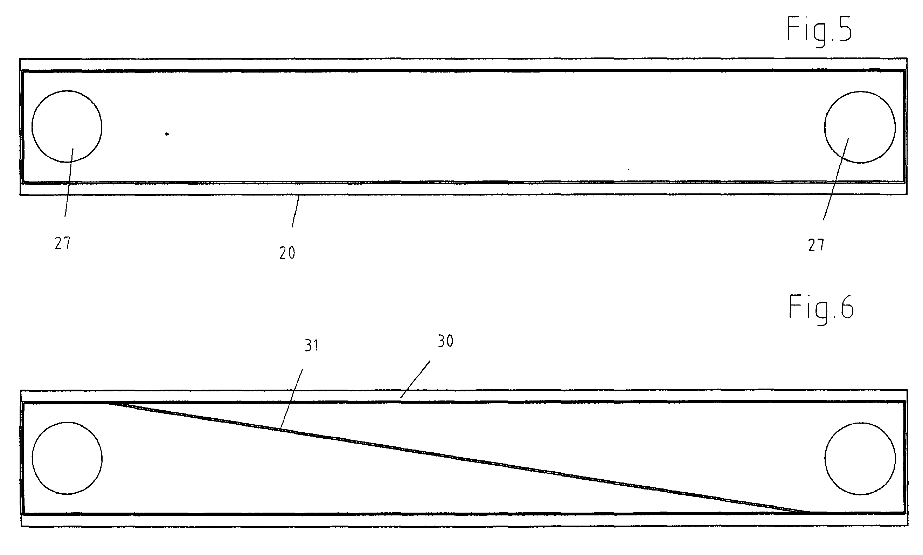

Zu diesem Zweck wird die Deckeltrennwand 31 beispielsweise im wesentlichen diagonal verlaufend im Deckelraum des Deckels 30 angeordnet (siehe Fig. 6), so dass die eine seitlich neben der Kammer 1 angeordnete Öldiffusionspumpe 21 den Kompartmentraum 34, der mit dem benachbarten Prozesskompartment 5 bzw. 8 verbunden ist, abpumpt und die andere Öldiffusionspumpe den zentralen Kompartmentbereich 35.

Da die Deckel 20 bzw. 30 austauschbar sind und im übrigen in einfacher Weise auf der Kammer 1 bzw. den entsprechenden Kompartments 2 bis 8 bzw. 17 angebracht werden können, können die vom Grundaufbau her identischen Kompartments 2 bis 8 bzw. 17 in einfacher Weise von einem Beschichtungskompartment oder einfachen Pumpkompartment in ein Teilkompartment einer Gastrenntstufe umgebaut werden, indem beispielsweise ausgehend von der Ausführungsform der Fig. 1 die Deckel 20 und 15 von den Kompartments 6 und 7 abgenommen, die entsprechenden Werkzeuge aus den Kompartments 6 und 7 entnommen und durch Trennwandeinbauten 32, 33 ersetzt werden und anschließend neue Gastrennstufendeckel 30 aufgesetzt werden. Dies zeigt, wie variabel eine Vakuumbehandlungsanlage mit dem neuartigen Deckelaufbau ist, insbesondere wenn man bedenkt, dass auch Deckel mit Turbomolekularpumpen, Diffusionspumpen und/oder Prozesswerkzeugen austauschbar ausgebildet sind.

Die Fig. 5 zeigt in einer ähnlichen Ansicht wie in der Fig. 6 den Unterschied zwischen einem Deckel für eine Gastrennstufe und einem Deckel für ein Pumpkompartment.

## Patentansprüche

1. Vakuumbehandlungsanlage, insbesondere Beschichtungsanlage für die kontinuierliche Beschichtung durchlaufender, plattenartiger Substrate, vorzugsweise Glasbeschichtungsanlage mit mindestens einer, vorzugsweise mehreren hintereinander angeordneten Vakuumkammern (1) oder Kammerbereichen (2 bis 8, 17), die über mindestens eine, vorzugsweise mehrere Pumpeinrichtungen (21) abgepumpt werden, wobei mindestens eine Kammer oder ein Kammerbereich an der Kammeroberseite einen abnehmbaren Deckel (20, 30) aufweist, an dem mindestens eine Pumpeinrichtung angeordnet ist, **dadurch gekennzeichnet, dass** der Deckel so ausgebildet ist, dass er einen Deckelraum (28) bildet und mindestens eine Anschlusseinrichtung für eine Diffusionspumpe, vorzugsweise Öldiffusionspumpe aufweist.

2. Vakuumbehandlungsanlage nach Anspruch 1, **dadurch gekennzeichnet, dass** der Deckel mit dem Deckelraum über die Kammer oder den Kammerbereichen übersteht und zwar vorzugsweise seitlich quer zur Substratförderrichtung über mindestens eine, vorzugsweise beide Seiten der Kammer übersteht.

3. Vakuumbehandlungsanlage nach Anspruch 1 oder 2, **dadurch gekennzeichnet, dass** an der Unterseite des Deckels im überstehenden Bereich mindestens eine vorzugsweise vakuumdicht verschließbare Anschlusseinrichtung (27) für eine Diffusionspumpe, vorzugsweise Öldiffusionspumpe (21), angeordnet ist.

4. Vakuumbehandlungsanlage nach einem der vorhergehenden Ansprüche, **dadurch gekennzeichnet, dass** der Deckelraum (28) im Deckel durch einen quader- oder kastenförmigen, im Bereich der Vakuumkammer zumindest teilweise nach unten offenen Aufbau des Deckels gebildet ist.

5. Vakuumbehandlungsanlage nach einem der vorhergehenden Ansprüche, **dadurch gekennzeichnet, dass** an der Oberseite des Deckels mindestens eine vorzugsweise vakuumdicht verschließbare Anschlusseinrichtung für eine Turbomolekularpumpe oder/und an der Unterseite Anordnungsmöglichkeiten für Prozesswerkzeuge vorgesehen sind.

6. Vakuumbehandlungsanlage nach einem der vorhergehenden Ansprüche, **dadurch gekennzeichnet, dass** die Kammer so ausgebildet ist, dass unterschiedliche Deckel an ihr lösbar befestigbar sind und sie durch diese vakuumdicht verschließbar ist, wobei die Deckel umfassen: überstehende Deckel mit Deckelraum mit (30) oder ohne Trenn- oder Leitbleche (20), Deckel mit am Deckel angeordneten Prozesswerkzeugen (15) und/oder Deckel mit Turbomolekularpumpen.

7. Vakuumbehandlungsanlage nach einem der vorhergehenden Ansprüche, **dadurch gekennzeichnet, dass** der Deckel ein Drosselventil (22) aufweist, welches vorzugsweise gegenüberliegend der Anschlusseinrichtung (27) der Pumpeinrichtung (21) vorgesehen ist und vorzugsweise durch ein von der Anschlusseinrichtung abhebbare Verschlussklappe gebildet ist, welche durch einen Linearantrieb in Bezug zur Öffnung der Anschlusseinrichtung bewegbar ist.

8. Vakuumbehandlungsanlage nach einem der vorhergehenden Ansprüche, **dadurch gekennzeichnet, dass** der Deckel (30) mindestens ein Trenn- oder Leitblech (31) aufweist, mittels dem der Deckelraum in separate Bereiche zum getrennten Abpumpen unterteilt ist.

9. Vakuumbehandlungsanlage nach Anspruch 8, **dadurch gekennzeichnet, dass** ein Trennblech (31) diagonal den Deckelraum durchquerend angeordnet ist, so dass mittels der auf beiden Seiten der Kammer angeordneten Pumpeinrichtungen, insbesondere Diffusionspumpen, unterschiedliche Bereiche abgepumpt werden.

10. Vakuumbehandlungsanlage nach Anspruch 9, **dadurch gekennzeichnet, dass** in der Kammer ein parallel zu dem Trennblech des Deckels verlaufendes und mit diesem vorzugsweise im wesentlichen gas- oder vakuumdicht lösbar verbundenes Kammertrennblech (32) zur Bildung einer Gastrennstufe vorgesehen ist.

11. Deckel für die Kammer einer Vakuumbehandlungsanlage insbesondere nach einem der vorhergehenden Ansprüche mit einem kastenartigen oder quaderförmigen Aufbau zur Bildung eines Deckelraums (28) und mindestens einem, vorzugsweise zwei Anschlusseinrichtungen (27) für Diffusionspumpen (21), vorzugsweise Öldiffusionspumpen vorzugsweise an der Unterseite im Bereich der Schmalseiten, vorzugsweise mit einem der kennzeichnenden Merkmale der Ansprüche 5 und 7 bis 9.
